# FASCICULE DE BREVET EUROPEEN

(11) **EP 2 286 441 B1**
(45) Date de publication et mention de la délivrance du brevet: **10.07.2019**
(21) Numéro de dépôt: 09750015.1
(22) Date de dépôt: 11.05.2009
(51) Int. Cl.: H01L 21/67, G01N 21/95, H01L 21/687

(54) **DISPOSITIF ET PROCÉDÉ D' INSPECTION DE PLAQUETTES SEMI-CONDUCTRICES**
VORRICHTUNG UND VERFAHREN ZUR ÜBERPRÜFUNG VON HALBLEITERWAFERN
DEVICE AND METHOD FOR INSPECTING SEMICONDUCTOR WAFERS

(30) Priorité: 13.05.2008 FR 0802586
(43) Date de publication de la demande: 23.02.2011
(73) Titulaire: Unity Semiconductor, 38330 Montbonnot-Saint-Martin (FR)
(72) Inventeur: GASTALDO, Philippe, F-38530 Pontcharra (FR); BERGER, François, F-38890 Saint Chef (FR); SERRECCHIA, Cleonisse, F-38530 Chapareillan (FR)
(74) Mandataire: IPAZ
(86) Numéro de dépôt international: PCT/FR2009/000544
(87) Numéro de publication internationale: WO 2009/141534

(56) Documents cités:
- EP-A- 0 735 361
- WO-A-02/29886
- JP-A- 11 219 990
- US-A- 5 933 230
- US-A1- 2004 012 775
- US-A1- 2004 174 518
- US-B1- 6 648 730
- US-B1- 6 748 293

## Description

L'invention relève du domaine de l'inspection et du contrôle de plaquettes semi-conductrices ou substrats en cours ou en fin de fabrication, ou lors de la réalisation de circuit intégrés.

La tendance à l'accroissement des diamètres des plaquettes semi-conductrices fait que celles-ci doivent être manipulées avec un soin extrême et sont de plus en plus fragiles. Par ailleurs, la gravure de plus en plus fine des motifs d'une plaquette semi-conductrice rend chaque composant de la plaquette de plus en plus sensible aux défauts de fabrication.

De façon classique, l'inspection visuelle des plaquettes semi-conductrices par un opérateur, est réalisée. L'oeil humain est en effet capable de discerner les défauts de relativement petite taille sur des plaquettes semi-conductrices ayant, pour un observateur non exercé, l'aspect d'un miroir. Plus la qualité de fabrication est élevée, plus l'oeil humain est capable de repérer des défauts de petite taille. Toutefois, l'évolution des techniques de gravure allant dans le sens d'une finesse toujours accrue, fait que l'oeil humain atteint des limites, notamment pour certains types de défauts.

Par ailleurs, la tâche d'inspection visuelle des plaquettes semi-conductrices est lente et fastidieuse. Dans une salle blanche de production de plaquettes semi-conductrices, il est souhaitable de réduire la présence humaine. L'inspection visuelle s'avère également onéreuse. Les machines d'inspection sont généralement lentes, encombrantes, ce qui est un inconvénient notable en salle blanche tout en mettant en oeuvre des rayonnements électromagnétiques nécessitant des protections particulières pour les opérateurs. Enfin, l'inspection visuelle ne génère pas de données statistiques suffisantes sur des positions, tailles ou types de défauts, ceci étant indispensable dans le suivi statistique de procédés et la recherche des causes de défaillances ou de problèmes.

Les documents US 2004/012775 A1 et JP 11 219990 A décrivent des systèmes d'inspection de plaquettes automatisés.

L'invention vient améliorer la situation.

Le dispositif d'inspection de plaquettes semi-conductrices comprend un bras de transport de plaquettes muni d'au moins un élément de support de plaquettes, une pince de saisie de plaquettes, au moins une source de lumière et au moins une caméra disposée d'un côté, et au moins deux systèmes d'inspection disposés d'un côté et de l'autre de la plaquette en position sensiblement verticale, symétriquement par rapport au plan passant par la plaquette. Chaque caméra d'un système d'inspection peut être positionnée pour capter la lumière réfléchie par la surface de la plaquette lui faisant face. Chaque source de lumière peut être positionnée pour émettre un faisceau incident vers ladite surface. La pince peut comprendre deux branches distantes configurées pour tenir des bords opposés de la plaquette. La pince peut être montée à rotation sur un arbre pour pouvoir tourner la plaquette entre une position sensiblement horizontale et une position sensiblement verticale.

Le procédé d'inspection de plaquettes semi-conductrices comprend les étapes suivantes :
- une plaquette semi-conductrice à inspecter est apportée par au moins un élément de support appartenant à un bras de transport,
- les branches distantes faisant partie d'une pince, saisissent des bords opposés de la plaquette,
- la pince tourne autour d'un arbre faisant passer la plaquette d'une position sensiblement horizontale à une position sensiblement verticale, et
- au moins deux systèmes d'inspection disposés d'un côté et de l'autre de la plaquette en position sensiblement verticale, symétriquement par rapport au plan passant par la plaquette sont actionnés.

L'invention sera mieux comprise à la lecture de la description détaillée de quelques modes de réalisation pris à titre d'exemples nullement limitatifs et illustrés par les dessins annexés sur lesquels :
- la figure 1 est une vue schématique en perspective d'une machine d'inspection de disques plats, tels que des plaquettes semi-conductrices, un système d'inspection ayant été retiré pour une meilleure compréhension du dessin ;
- la figure 2 est une vue de face en élévation de la machine de la figure 1, des éléments de châssis et de capot ayant été retirés pour une meilleure compréhension du dessin ;
- la figure 3 est une vue de dessus de la machine de la figure 1;
- la figure 4 est une vue schématique de côté de la pince dans une première position;
- la figure 5 est une vue schématique de côté de la pince dans une deuxième position;
- la figure 6 est une vue en coupe transversale d'une branche de la pince ;
- les figures 7 et 8 sont des organigrammes d'étapes de procédé ; et
- la figure 9 est une vue de dessus d'une machine d'inspection de disques plats.

De façon générale, les machines d'inspection actuelle sont prévues pour une plaquette semi-conductrice en position horizontale reposant sur un plateau, voir US 2008/7726, JP 100 56 046 et KR 2004 0024795. Il en va de même du document EP 1 194 803 qui propose en outre une structure catadioptrique complexe.

La Demanderesse s'est rendue compte que l'inspection de plaquettes semi-conductrices en position horizontale présentait différents inconvénients. D'une part, la planéité des plaquettes se trouve affectée par la gravité et donc une déformation sous son propre poids, ceci étant d'autant plus important que le diamètre de la plaquette est grand. Les plaquettes peuvent présenter un diamètre de 300 mm, voire de 450 mm. La solution généralement retenue consiste en l'utilisation d'une surface de référence d'une planéité meilleure que celle mesurable, sur laquelle la plaquette est posée ou maintenue pendant la mesure. Cette surface de référence est en général celle d'un support massif. Le contact entre cette surface et la plaquette est source de contamination de la face arrière. D'autre part, cette méthode masque la face arrière pendant la mesure de la face avant.

Le document US 2006/18548 décrit un mécanisme de retournement de photos-masque permettant de faire inspecter par une machine d'inspection une face puis l'autre d'un photo-masque. Le mécanisme de retournement est inadapté à des cadences industrielles en ce qu'il tend à diviser par deux le rendement de la machine d'inspection proprement dite. En outre, le photo-masque n'est porté que par ses bords en position horizontale lors de l'inspection, ce qui indique que le photo-masque présente un rapport épaisseur sur longueur élevé, ce qui n'est pas le cas des plaquettes semi-conductrices.

Le document US 2007/188 745 décrit un dispositif d'inspection des deux faces d'une plaquette semi-conductrice en position oblique. Une plaquette semi-conductrice est disposée sur un mécanisme de support à air permettant à la plaquette semi-conductrice d'être supportée de façon flottante. La face inférieure de la plaquette semi-conductrice est inspectée par une tête de balayage mobile en translation selon un axe, la tête de balayage présentant une longueur très inférieure au diamètre de la plaquette semi-conductrice. La plaquette semi-conductrice est entraînée en rotation par des rouleaux de support contre lesquels le bord de la plaquette semi-conductrice est en appui. Par combinaison de la rotation de la plaquette et du déplacement en translation de la tête de balayage, la surface inférieure de la plaquette peut progressivement être inspectée, la position inclinée assurant un certain appui du bord de la plaquette sur les rouleaux. Toutefois, l'inspection de la face supérieure nécessite des moyens spéciaux en raison de l'inclinaison de la plaquette. L'inspection de la face inférieure est particulièrement lente de par la structure même du dispositif. La plaquette risque de vibrer et/ou de se déformer sous le flux d'air qui la maintient en position flottante.

Grâce à l'invention, la plaquette maintenue immobile en position sensiblement verticale lors de l'inspection présente un risque de déformation particulièrement réduit. On entend ici par sensiblement verticale à +/- 5° près. La structure symétrique du dispositif permet un écoulement régulier du flux d'air laminaire au sein du dispositif et réduit le risque de contamination de la plaquette semi-conductrice par des poussières ou autres éléments néfastes lors de l'inspection (cela ne peut être le cas lors d'une inspection en position inclinée, l'air étant dévié unilatéralement).

Par ailleurs, l'impact de l'écoulement de l'air sur la stabilité mécanique de la plaquette semi-conductrice est réduit. Les vibrations mécaniques sont réduites. La position verticale à la plaquette semi-conductrice évite une déformation sous son propre poids, ce qui permet d'éviter la mise en oeuvre d'un plateau rectifié encombrant et lourd. Le risque de contamination de la surface inférieure de la plaquette semi-conductrice est particulièrement réduit, dans la mesure où la plaquette est saisie par des pinces venant en contact avec son bord extérieur.

La surface inférieure de la plaquette semi-conductrice est disponible pour une inspection qui peut avoir lieu dans la même position verticale d'où la possibilité accrue d'établir des corrélations entre les défauts de la surface supérieure et les défauts de la surface inférieure. Par ailleurs, le fait de mener l'inspection de la surface arrière dans la même position que l'inspection de la surface supérieure permet un gain de temps significatif. La stabilité de la plaquette semi-conductrice, pendant les opérations de mesure, réduit les risques de contamination, diminue drastiquement les vibrations mécaniques et augmente la fiabilité des mesures.

Les surfaces opposées de la plaquette sont dites supérieure et inférieure par convention, même lorsque la plaquette est en position verticale, par référence à la position horizontale de la plaquette supportée par la fourche, avant et après l'inspection en position verticale.

Les éléments de support prévus pour supporter une plaquette en amont et en aval de la pince peuvent former une fourche. Les éléments de support peuvent ainsi déplacer la plaquette en position horizontale tout en restant à distance des branches de la pince. La fourche assure une bonne stabilité mécanique de la plaquette semi-conductrice et une déformation sous son propre poids dans des limites acceptables au cours du transport. Le bras de transport peut comprendre au moins deux axes d'articulation. Le bras de transport peut être supporté par une tourelle. La tourelle peut supporter deux bras de transport de plaquettes. La tourelle peut être montée à translation sur une glissière. La tourelle à deux bras de transport permet d'optimiser le mouvement de la plaquette entre un stockage de plaquettes et la pince de saisie.

Chaque branche de la pince peut présenter une rainure ménagée sur une surface disposée en regard de l'autre branche. La rainure peut être configurée en fonction de la forme du bord de la plaquette. La rainure peut présenter une forme générale en V en section axiale. La rainure peut assurer un auto centrage de la plaquette.

Au moins une des branches de la pince est montée à pivotement selon un axe sensiblement perpendiculaire au plan de la plaquette tenue entre lesdites branches. Préférablement, les deux branches sont montées à pivotement selon des axes parallèles ou selon un axe commun. Les éléments de transport peuvent présenter un encombrement latéral inférieur à l'ouverture entre les branches de la pince. On limite ainsi les risques d'interférence mécanique entre les éléments de transport et la pince.

Chaque source de lumière peut comprendre un moniteur de diagonale supérieure à l'ouverture maximale entre les branches de la pince. On assure ainsi un excellent éclairage des surfaces opposées de la plaquette semi-conductrice. La source de lumière peut comprendre un écran LCD ou plasma. La caméra peut être disposée au-dessus de la source de lumière correspondante.

Le dispositif peut comprendre une unité de commande configurée pour commander l'affichage de raies parallèles par les sources de lumière. L'unité de commande peut être configurée pour commander une alternance de raies verticales et de raies horizontales affichées par les sources de lumière.

L'unité de commande peut comprendre au moins une sortie reliée à une caméra et au moins une sortie reliée à la source de lumière correspondante pour synchroniser ladite caméra et ladite source de lumière. Avantageusement, l'unité de commande pilote les deux caméras et les deux sources de lumière symétriques, avec des paramètres tels que les temps d'exposition ou le mode d'illumination propres aux caractéristiques de chaque face.

L'unité de commande peut être configurée pour commander une zone ovale éclairée de la source de lumière et un bord extérieur sombre. On optimise ainsi la lumière atteignant la surface de la plaquette semi-conductrice, en augmentant la proportion de lumière incidente. De même, on diminue la proportion de lumière incidente ou diffusée captée par les caméras. La saturation diminue. Le contraste s'en trouve amélioré.

L'unité de commande peut être configurée pour commander l'affichage de couleurs différentes simultanément par les sources de lumière en vue d'optimiser la qualité de détection.

L'unité de commande peut être configurée pour commander un éclairage alterné par lesdites sources de lumière. On réduit ainsi la proportion de lumière diffusée atteignant les caméras. En effet, lors de l'éclairage de la plaquette semi-conductrice par une source de lumière, une partie du faisceau incident peut traverser la plaquette semi-conductrice et subir des phénomènes de diffraction et atteindre la caméra située du côté opposé. Bien entendu, ce phénomène dépend de la réflectivité de la plaquette semi-conductrice. Dans le cas d'une plaquette particulièrement réfléchissante, le phénomène est relativement peu gênant et l'éclairage peut être simultané. Au contraire, dans le cas d'une plaquette semi-conductrice relativement peu réfléchissante, l'éclairage alterné permet une meilleure résolution de la détection.

L'unité de commande peut être configurée pour commander la prise d'images par les caméras de façon alternée ou simultanée, notamment en synchronisation avec un éclairage alterné ou simultané. Chaque image peut être prise pendant une durée d'exposition de l'ordre de 100 à 3000 millisecondes. Le temps de transfert par les caméras peut être de l'ordre de 5 à 600 millisecondes. La prise d'images alternée ou simultanée permet d'optimiser la durée de l'inspection en comparaison à une inspection d'une face puis de l'autre.

Par ailleurs, les caméras peuvent être munies d'un obturateur électronique ou mécanique. La synchronisation entre la prise d'images par une caméra et l'éclairage par la source de lumière correspondante peut remplacer l'obturateur électronique ou mécanique en assurant une prise d'images de qualité. Dans ce cas, la durée d'éclairage peut être comprise entre 100 et 3000 millisecondes.

Les caméras peuvent être munies d'un objectif dit à bascule. On peut mieux observer les bords de la plaquette semi-conductrice en raison du basculement du plan focal. L'écran LCD ou plasma du moniteur peut comprendre un panneau dépoli, ce qui permet de diminuer les résidus de franges liés à la génération d'une harmonique liée à la périodicité des pixels de l'écran et à la présence de zones mortes. Le dépolissage peut être effectué à l'acide ou par un dépoli mécanique type sablage ou polissage. On obtient de la sorte une précision d'inspection de défauts de l'ordre du nanomètre perpendiculairement à la surface observée.

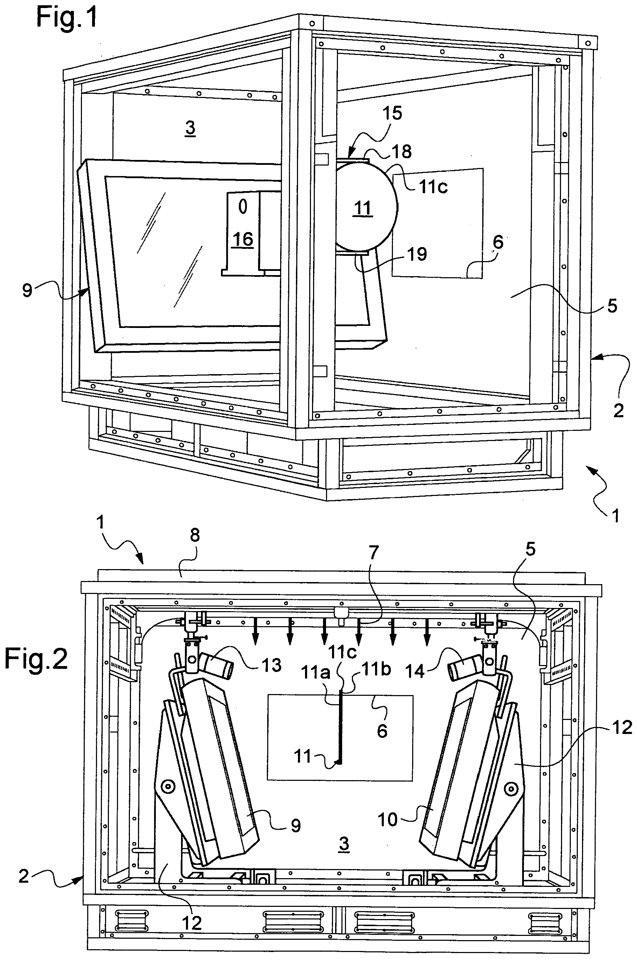

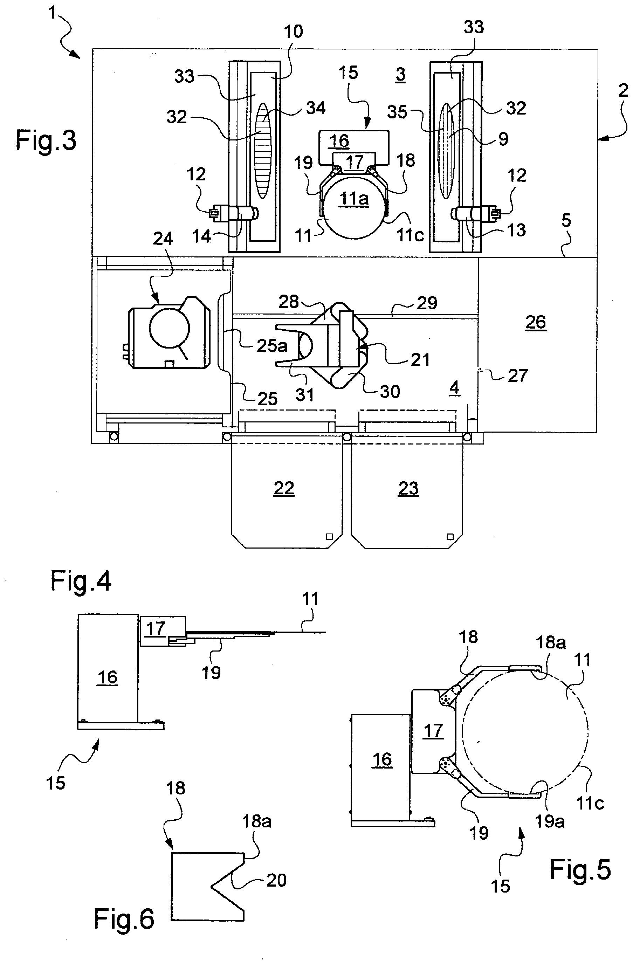

Sur les figures 1 à 3, la machine d'inspection 1 a été représentée capot ouvert. Plus précisément, sur la figure 1, le capot avant et l'un des capots latéraux sont ouverts. Sur la figure 2, le capot avant est ouvert. Sur la figure 3, le capot de dessus est ouvert. Bien entendu, en état de fonctionnement, la machine d'inspection 1 est munie de ses capots fermés. Les capots sont opaques pour éviter l'introduction de lumière parasite susceptible de venir perturber les caméras. En outre, sur la figure 1, l'un des deux écrans, la caméra correspondante et le support de la pince ont été omis afin de mieux voir les autres pièces. De même, sur la figure 2, la pince et le support de pince ont été omis, le substrat y étant présenté en position d'inspection, sensiblement vertical.

Comme on peut le voir sur les figures 1 à 5, la machine d'inspection 1 comprend un bâti 2, par exemple de type mécano-soudé formant une chambre d'inspection 3 et une chambre d'alimentation 4 séparées par une cloison 5 percée d'une fenêtre 6. Le bâti 2 est recouvert par les capots.

La chambre d'inspection 3 présente une structure symétrique par rapport à un plan vertical passant le milieu des figures 2 et 3. La machine d'inspection 1 comprend une alimentation 8 en air filtré de type laminaire permettant de générer un déplacement d'air du haut vers le bas de la chambre 3 comme montré par les flèches 7. L'alimentation 8 en air forme également la paroi supérieure de la chambre 3. Le plancher de la chambre de mesure est constitué d'un empilement de 2 grilles dont l'une peut être décalée de l'autre, ceci permettant de contrôler le débit d'air sortant par cette issue, et ainsi de contrôler la surpression dans la chambre de mesure.

La machine d'inspection 1 comprend deux écrans vidéo 9 et 10 montés symétriquement, notamment par rapport à un plan vertical passant par le centre de la machine d'inspection 1 ou encore passant par le substrat 11 à inspecter maintenu en position verticale, voir figures 1 et 2. Chaque écran 9, 10 repose sur un support 12, par exemple du type articulé permettant une orientation de l'écran 9, 10 selon un axe sensiblement parallèle au plan du substrat 11, par exemple un axe sensiblement horizontal, et le réglage en translation de la position de l'écran 9, 10 par rapport à la surface mesurée. Les écrans 9 et 10 sont montés en regard l'un de l'autre à distance et légèrement orientés vers le haut, par exemple avec un angle compris entre 10 et 30°. Les écrans 9 et 10 peuvent être du type LCD ou plasma. Les écrans 9, 10 présentent une hauteur supérieure à 1,6 fois le diamètre du substrat à inspecter, par exemple une hauteur de 54 cm pour un substrat de 300 mm de diamètre et une hauteur de 72 cm pour un substrat de 450 mm de diamètre.

Les côtés de l'écran d'illumination sont dits hauteur et largeur par convention. On entend par hauteur la dimension la plus petite de la zone d'affichage de l'écran, par référence à l'orientation de l'écran en utilisation d'afficheur vidéo habituelle.

La machine d'inspection comprend également deux caméras 13, 14 situées dans la chambre d'inspection 3. Les caméras 13, 14 peuvent être supportées par les supports 12. Un support 12 est commun à un écran, 9 ou 10 et à une caméra 13 ou 14. La caméra 13 est cachée sur la figure 1 par un montant du bâti 2. Les caméras 13, 14 peuvent également être réglées en position, notamment en hauteur, en largeur et en longueur, la longueur correspondant à la distance horizontale par rapport au substrat 11. En outre, les caméras 13 et 14 peuvent être réglées en orientation angulaire. Les caméras peuvent être de type CCD (Charge Coupled Device en langue Anglaise) ou CMOS (Complementary Metal Oxyde Semiconductor). L'écran 9 et la caméra 13 forment un premier système d'inspection. L'écran 10 et la caméra 14 forment un deuxième système d'inspection. Les premier et deuxième systèmes d'inspection sont symétriques. Les positions respectives de l'écran 9, du substrat 11 et de la caméra 13 d'un côté, de l'écran 10, du substrat 11 et de la caméra 14 de l'autre côté de la chambre d'inspection 3 sont choisies de façon que chaque écran 9, 10 émette un faisceau incident atteignant le substrat 11 sur sa face correspondante 11a, 11b respectivement et que la caméra 13, 14 capte le faisceau réfléchi par ladite surface 11a, 11b. Les faces 11a et 11b sont parallèles. Le faisceau incident n'atteint pas en totalité le substrat 11. Les positions relatives sont choisies de façon que la surface 11a, 11b soit suffisamment éclairée pour permettre à la caméra 13, 14 de détecter un signal lumineux représentatif de défauts de la surface 11a, 11b. La luminosité et le contraste de l'écran 9, 10 sont réglés à des niveaux élevés pour favoriser la détection des défauts par les caméras 13, 14. Par ailleurs, les surfaces inactives de la chambre 3 présentent une absorption maximale des longueurs d'onde utilisées. En d'autres termes, les surfaces inactives de la chambre d'inspection 3 sont de couleur noire. On limite ainsi la perturbation des caméras 13, 14.

Les caméras 13, 14 étant inclinées par rapport à la normale aux surfaces 11a, 11b, présentent une légère distorsion, la distance entre l'extrémité supérieure de la surface 11a et l'objectif de la caméra étant inférieure à la distance entre l'extrémité inférieure de la surface 11a et l'objectif de la caméra 13. Il en va de même pour la caméra 14 par rapport à la surface 11b lui faisant face. À cet effet, les caméras 13, 14 peuvent comprendre un objectif basculant permettant de réduire la distorsion et d'obtenir une meilleure observation de la zone périphérique des surfaces 11a et 11b.

La machine d'inspection 1 comprend une pince 15 de maintien du substrat 11. La pince 15, visible sur les figures 1 et 3 est représentée plus en détail sur les figures 4 et 5 offrant au substrat 11 une position respectivement horizontale de réception et verticale d'inspection. La pince 15 comprend une base 16 reposant sur le bâti 2, une tourelle 17 et deux branches 18 et 19. La base 16 peut présenter une forme générale de parallélépipède rectangle. La tourelle 17 est articulée sur la base 16 selon un axe sensiblement horizontal et passant par la fenêtre 6. La tourelle est prévue pour assurer une rotation d'au moins 90°. Une rotation de 180° peut permettre de retourner un substrat 11 ce qui peut s'avérer intéressant dans certaines applications. La rotation de la tourelle 17 peut être assurée par un entraînement électromécanique disposé dans la base 16, par exemple un moteur pas à pas.

Les branches 18 et 19 sont symétriques par rapport à un plan normal au substrat 11, lorsque ledit substrat 11 est porté par lesdites branches 18 et 19. Chaque branche 18, 19 est articulée sur la tourelle 17 selon un axe propre, décalé par rapport à l'axe de pivotement de la tourelle 17 et normale au substrat 11. Dans une variante, les branches 18 et 19 peuvent être coaxiales. Dans une autre variante, l'une des branches est stationnaire par rapport à la tourelle 17 et l'autre branche est articulée. La tourelle 17 comprend un organe d'actionnement des branches 18, 19, par exemple sous la forme de deux moteurs pas à pas ou encore d'un moteur pas à pas et d'un engrènement permettant aux branches 18 et 19 de rester symétriques quelque soit leur position angulaire. Les branches 18 et 19 peuvent pivoter entre deux positions de travail, une position ouverte utilisée pour approcher ou éloigner le substrat 11 et une position en prise avec le bord extérieur 11c du substrat 11. Les figures 4 et 5 montrent la position en prise.

Plus particulièrement, chaque branche 18, 19 présente une forme coudée de façon que l'encombrement de la tourelle 17 soit inférieur au diamètre du substrat 11. En d'autres termes, les branches 18, 19 présentent une forme d'accent circonflexe. Les branches 18, 19 présentent chacune une face interne 18a, 19a en regard de la face interne de l'autre branche 19, 18, et prévue pour venir en contact avec le bord extérieur 11c du substrat 11. La face interne 18a, 19a présente une rainure 20 allongée parallèlement à l'axe de pivotement de la tourelle 17. La rainure 20 visible sur la figure 6, peut présenter une section transversale en V ou alternativement en demi-cercle ou en ogive pour convenablement coopérer avec le bord extérieur 11c du substrat 11 et assurer une retenue aussi bien dans la position horizontale du substrat 11 illustrée sur la figure 4 que dans la position verticale illustrée sur la figure 5 et dans des positions intermédiaires et ce, avec un faible serrage réduisant à des valeurs négligeables la déformation du substrat 11, notamment le flambage en position d'inspection.

La machine d'inspection 1 comprend un organe de manipulation 21 de substrat prévu pour apporter un substrat 11 à la pince 15 avant inspection et pour décharger le substrat de la pince 15 après l'inspection. L'organe de manipulation 21 est disposé dans la chambre d'alimentation 4. L'organe de manipulation 21 peut se présenter sous la forme d'un robot pourvu d'un élément de travail capable de passer par la fenêtre 6 ménagée dans la cloison 5.

La machine d'inspection 1 comprend deux conteneurs 22, 23 amovibles pour stocker une pluralité de substrats 11. Les conteneurs 22, 23 sont supportés par une paroi de la chambre 4 du côté opposé à la cloison interne 5. Les conteneurs 22, 23 peuvent du type auto-obturant de manière à se fermer lors d'une séparation d'avec la machine d'inspection 1. De même, la paroi de la chambre d'alimentation 4 est munie d'une fenêtre au droit des conteneurs 22, 23, préférablement munie d'un obturateur automatique fermant la chambre d'alimentation 4 avant le retrait complet des conteneurs 22, 23. On limite ainsi la pollution des substrats 11 et des chambres de la machine d'inspection 1 par des poussières.

La machine d'inspection 1 comprend un organe de préalignement 24 pour les substrats 11. L'organe de préalignement 24 peut être disposé le long de la cloison 5 à une extrémité longitudinale de la chambre d'alimentation 4. L'organe de préalignement 24 et la chambre d'alimentation 4 sont séparés par une cloison 25 percée d'une ouverture 25a permettant le passage d'un substrat 11 porté par l'organe de manipulation 21. En outre, la machine d'inspection 1 comprend une unité de commande et de traitement 26 pouvant se présenter sous la forme d'une baie électronique. L'unité de commande 26 est disposée à l'extrémité de la chambre d'alimentation 4 opposée à l'organe de préalignement 24 avec une cloison de séparation 27. L'unité de traitement 26 peut également être en contact avec la cloison 5. L'unité de commande 26 est reliée aux écrans 9 et 10, aux caméras 13 et 14, à la pince 15 et à l'organe de manipulation 21.

L'organe de manipulation 21 comprend une tourelle 28 capable de se déplacer en translation par rapport au bâti 2 selon un axe parallèle à la cloison 5. Ainsi, l'organe de manipulation 21 peut venir à proximité de l'ouverture 25a vers l'organe de préalignement 24 dans une position et venir au droit de la fenêtre 6, en face de la pince 15 dans une autre position, ou encore en face du conteneur 22, ou en face du conteneur 23. La tourelle 28 peut se déplacer le long d'une glissière 29 solidaire du bâti 2. L'organe de manipulation 21 comprend un bras 30 à deux axes d'articulation, supporté par la tourelle 28, et une fourche 31 supporté par l'extrémité du bras 30 opposé à la tourelle 28. Les axes d'articulation du bras 30 peuvent être sensiblement verticaux. En d'autres termes, le bras 30 est muni de deux axes d'articulation parallèles entre eux et normaux au plan d'un substrat 11 reposant sur la fourche 31.

La fourche 31 peut se présenter sous la forme d'une plaque d'épaisseur sensiblement constante de contour généralement rectangulaire avec une large échancrure ménagée à partir d'un petit côté et laissant subsister deux dents. L'échancrure peut être en forme générale de U légèrement évasé. Les dents de la fourche 31 forment un élément de transport de substrat. L'écartement entre les dents de la fourche 31 peut être adapté au diamètre du substrat à manipuler, par exemple compris entre 150 et 250 mm pour un substrat de 300 mm de diamètre ou encore compris entre 225 et 400 mm pour un substrat de 450 mm de diamètre. La fourche 31 est prévue avec un déplacement dans un plan horizontal grâce au déplacement de la tourelle 28 sur la glissière 29 et aux deux rotations autorisées par les deux axes d'articulation du bras 30. L'organe de manipulation 21 comprend un mécanisme de déplacement vertical, notamment en translation en vue d'ajuster la hauteur de la fourche 31 et par conséquent du substrat 11 porté par ladite fourche 31.

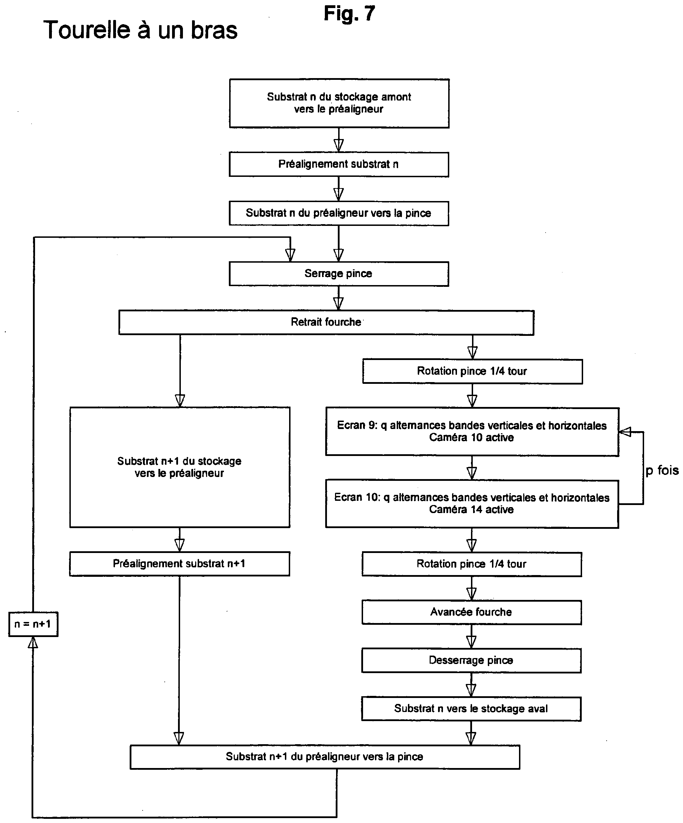

En fonctionnement, voir figure 7, l'unité de commande 26 commande l'organe de manipulation 21, la pince 15, les écrans 9 et 10 et les caméras 13 et 14. L'organe de manipulation 21 vient se présenter en face du conteneur 22 contenant une pluralité de substrats à inspecter. La fourche 31 passe sous un substrat 11 puis soulève ledit substrat 11 de quelques millimètres et se retire dudit conteneur 22 en supportant le substrat 11. L'organe de manipulation 21 déplace ensuite le substrat 11 jusqu'à l'organe de préalignement 24 qui assure un positionnement convenable du substrat 11, par exemple au moyen de trois doigts animés d'un mouvement radial et entrant en contact avec le bord extérieur 11c du substrat 11. Puis la fourche 31 assure une reprise du substrat 11 et le fait passer à travers la fenêtre 6 pour l'amener entre les branches 18 et 19 de la pince 15. La fourche 31 se situe très légèrement en dessous des branches 18 et 19 de façon que le substrat 11 soit situé au niveau des branches 18 et 19. Les branches 18 et 19 viennent serrer sur le bord extérieur 11c du substrat 11. La fourche 31 s'abaisse pour se dégager du substrat 11 désormais maintenu entre les branches 18 et 19, en particulier dans les rainures 20. L'organe de manipulation 21 rétracte alors la fourche 31, par exemple dans la chambre d'alimentation 4.

Le substrat 11 maintenu entre les pinces 18 et 19 dans une position d'origine sensiblement horizontale, est tourné d'un quart de tour pour l'amener dans la position sensiblement verticale illustrée sur la figure 1. L'unité de commande 26 procède ensuite à l'inspection proprement dite en commandant l'éclairage par l'écran 9 de la face 11a du substrat 11 immobilisé par la pince 15. L'écran 9 affiche des raies sensiblement verticales alternativement lumineuses et noires, puis des raies sensiblement horizontales 35 alternativement lumineuses (blanches ou de couleur), et noires, et ce, q fois avec q compris entre 1 et 20. Simultanément, la caméra 13 effectue une prise d'images, par exemple pendant une durée comprise entre 100 et 3000 millisecondes. La caméra 13 peut effectuer une succession de prises d'images pour chaque type de raie. Puis l'écran 9 est éteint et l'écran 10 allumé pour éclairer la face 11b du substrat 11. L'écran 10 affiche des raies semblables à celles de l'écran 9, notamment des raies verticales 34, voir figure 2. La caméra 14 prend simultanément un ou plusieurs images. Les images prises par les caméras 13 et 14 sont transférées à l'unité de commande 26 qui assure un traitement en vue de la vérification de la présence de défaut, notamment de défauts de planéité ou d'aspect des faces 11a et 11b du substrat. Ce mode de fonctionnement en séquentiel peut avantageusement être remplacé par un mode simultané, où le système écran-caméra inspectant la face supérieure et celui inspectant la face inférieure travaillent de façon autonome et simultanée.

Dans un mode de réalisation, l'éclairage est assuré par l'ensemble de la surface des écrans 9 et 10. La Demanderesse s'est aperçue qu'il était intéressant de limiter l'éclairage à une zone ovale 32 sur les écrans 9 et 10 correspondant à la projection géométrique des faces 11a et 11b respectivement du substrat 11 sur les écrans 9 et 10. Dans ce cas, les raies verticales 34 puis horizontales 35 sont affichées dans la zone ovale 32, le bord extérieur 33 de l'écran restant noir. On réduit la quantité de lumière diffusée dans la chambre d'inspection 3 et on réduit la perturbation des caméras 13 et 14 qui peuvent alors fournir un signal de qualité améliorée.

Ensuite, la phase d'immobilité du substrat 11 en position sensiblement verticale étant terminée, la tourelle 17 de la pince 15, commandée par l'unité de commande 26, tourne sensiblement d'un quart de tour pour remettre le substrat 11 en position sensiblement horizontale. La fourche 31 de l'organe de manipulation 21 s'avance sous le substrat 11 à une distance de sécurité, par exemple de l'ordre de quelques millimètres, puis se déplace verticalement en remontant à faible vitesse jusqu'à proximité de la face inférieure 11b du substrat 11. Les branches 18 et 19 passent alors de la position en prise à la position ouverte, le substrat 11 reposant sur la fourche 31.

La fourche 11 quitte la chambre d'inspection 3 et se déplaçant à travers la chambre d'alimentation 4, vient disposer le substrat 11 dans le conteneur 22 ou 23. Le cycle peut alors être répété. Bien entendu, pour augmenter la productivité de la machine d'inspection, l'organe de manipulation 21 peut être commandé pour prendre un substrat 11 et l'apporter à l'organe de préalignement 24 pendant les étapes au cours desquelles le substrat 11 précédemment apporté à la pince 15 est en cours d'inspection par les caméras 13 et 14.

Comme on peut le voir sur l'organigramme de la figure 7, les étapes d'éclairage par l'écran 9, 10 et d'observation par la caméra 13, 14, peuvent être répétées jusqu'à l'obtention de données suffisamment précises. Le nombre de sous-étapes p peut être compris entre 1 et 10.

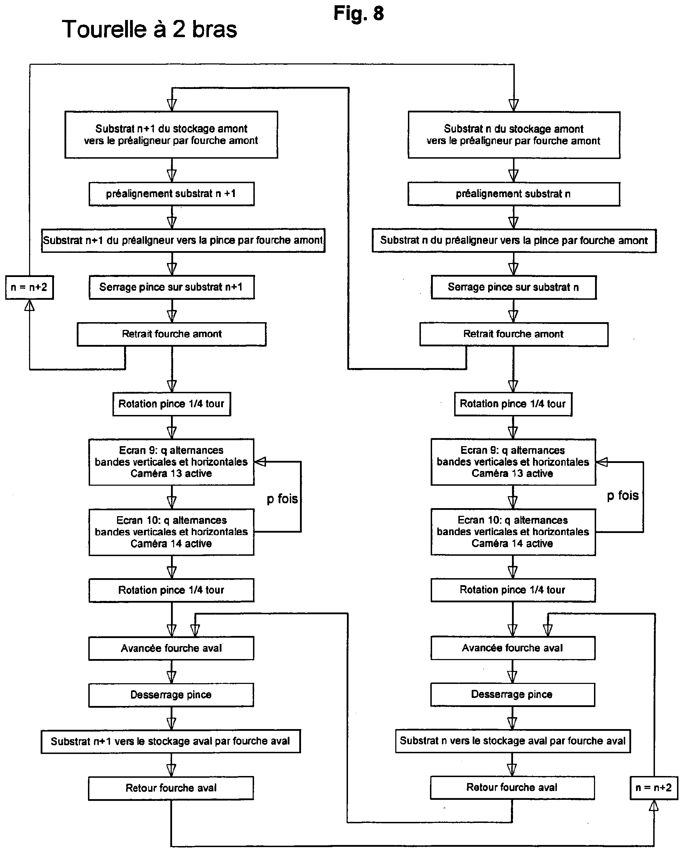

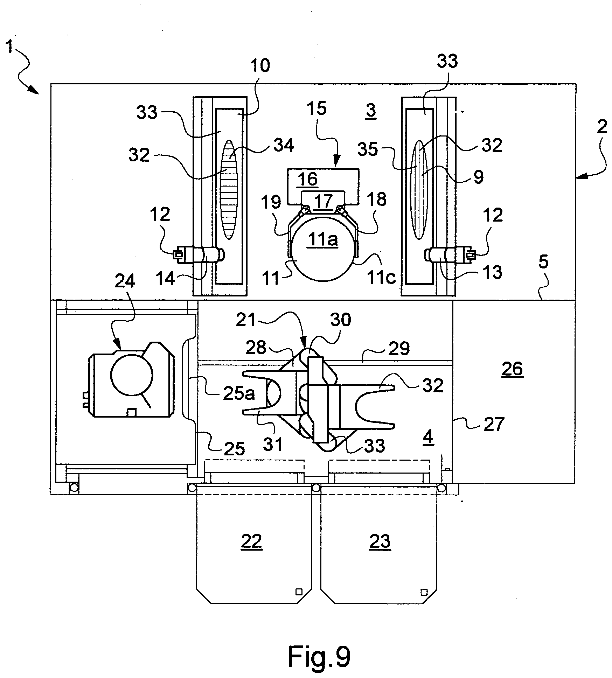

Dans le mode de réalisation de la figure 9, l'organe de manipulation 21 peut être muni d'une tourelle 28 supportant deux bras 30, 33 chacun muni d'une fourche 31, 32. La productivité de la machine d'inspection 1 peut alors être améliorée en suivant l'organigramme de la figure 8 dans la mesure où l'une des fourches dite amont, peut être dédiée aux étapes de manipulation préalables à l'inspection par les caméras 13 et 14, tandis que la fourche supplémentaire dite aval peut être dédiée aux étapes de manipulation postérieures à l'inspection par les caméras 13 et 14 pour ramener le substrat 11 inspecté de la pince 15 dans le conteneur 22 ou 23.

Plusieurs étapes peuvent être effectuées simultanément selon les durées respectives de chaque étape et notamment la durée de l'inspection par les caméras 13 et 14. Plus particulièrement, la fourche amont peut sortir un substrat de l'organe de pré alignement 24 alors que le substrat précédent est en cours d'inspection par les caméras 13 et 14, la fourche amont restant alors en attente de la sortie du substrat précédent par la fourche aval. Dès que la fourche aval a extrait le substrat 11 précédent de la chambre de traitement 3, la fourche amont peut introduire le substrat suivant dans ladite chambre de traitement 3. En d'autres termes, la durée entre deux étapes d'inspection par les caméras 13 et 14 est diminuée d'où un rendement plus élevé.

Par ailleurs, la fourche amont a deux manipulations à faire, l'amenée d'un substrat 11 à l'organe de préalignement 24, puis l'amenée du substrat 11 à la pince 15, tandis que la fourche aval a une opération de manipulation à réaliser: l'amenée du substrat 11 inspecté au conteneur aval 23. L'unité de commande 26 peut donner la priorité à la fourche amont 31, ce qui permet là encore de réduire légèrement le temps de cycle. Ainsi, la fourche aval peut rester avec un substrat inspecté en attente de rangement, tandis que la fourche amont effectue une autre opération, par exemple le prélèvement d'un substrat dans le conteneur 22 pour l'amener à l'organe de préalignement 24, ou encore le prélèvement d'un substrat 11 dans l'organe de préalignement 24.

Par ailleurs, l'unité de commande 26 peut être configurée pour faire fonctionner simultanément les sources de lumière formées par les écrans 9 et 10.

Les conteneurs 22 et 23 peuvent servir l'un de conteneur amont et l'autre de conteneur aval. Les conteneurs 22 et 23 peuvent servir l'un après l'autre, un substrat 11 prélevé dans le conteneur 22 y retournant après inspection, éventuellement dans la même position.

## Revendications

1. Dispositif d'inspection (1) de plaquettes semi-conductrices comprenant un bras (30) de transport de plaquettes muni d'au moins un élément de support de plaquettes, **caractérisé par le fait qu'**il comprend une pince (15) de saisie de plaquettes, la pince (15) comprenant deux branches (18, 19) distantes configurées pour tenir des bords opposés de la plaquette, la pince (15) étant montée à rotation sur un arbre pour pouvoir tourner la plaquette entre une position sensiblement horizontale et une position sensiblement verticale, et au moins deux systèmes d'inspection disposés d'un côté et de l'autre de la plaquette en position sensiblement verticale, symétriquement par rapport au plan passant par la plaquette, chacun des systèmes d'inspection comprenant au moins une source de lumière et au moins une caméra (13, 14), chaque source de lumière comprenant un écran (9, 10) sensiblement parallèle au plan de la plaquette (11) et positionné pour émettre un faisceau incident vers une des surfaces de la plaquette, chaque caméra (13, 14) étant positionnée pour capter la lumière réfléchie par la surface de la plaquette lui faisant face, les systèmes d'inspection étant actionnés lorsque la plaquette est immobile en position sensiblement verticale.

2. Dispositif selon la revendication 1, dans lequel le bras (30) de transport comprend au moins deux axes d'articulation et est supporté par une tourelle (28) supportant au moins un bras de transport de plaquettes, la tourelle (28) étant montée à translation sur une glissière (29).

3. Dispositif selon l'une des revendications précédentes, dans lequel chaque branche (18, 19) de la pince présente une rainure (20) ménagée sur une surface disposée en regard de l'autre branche.

4. Dispositif selon la revendication précédente, dans lequel la rainure (20) présente une forme générale en V.

5. Dispositif selon l'une des deux revendications précédentes, dans lequel au moins une des branches est montée à pivotement selon un axe sensiblement perpendiculaire au plan de la plaquette tenue entre lesdites branches.

6. Dispositif selon l'une des revendications précédentes, dans lequel les éléments de transport présentent un encombrement latéral inférieur à l'ouverture entre les branches de la pince (15) .

7. Dispositif selon l'une des revendications précédentes, dans Lequel chaque source de lumière comprend un moniteur (9,10) de dimension la plus faible supérieur à une fois et demie l'ouverture maximale entre les branches de la pince.

8. Dispositif selon la revendication précédente, dans lequel le moniteur (9, 10) comprend un écran LCD ou plasma.

9. Dispositif selon l'une des revendications précédentes, dans Lequel la caméra (13, 14) est disposée au-dessus de la source de lumière.

10. Dispositif selon l'une des revendications précédentes, comprenant une unité de commande (26) configurée pour commander l'affichage de raies parallèles par les sources de lumière.

11. Dispositif selon la revendication précédente, dans lequel l'unité de commande (26) comprend au moins une sortie reliée à une caméra et au moins une sortie reliée à la source de lumière correspondante pour synchroniser ladite caméra et ladite source de lumière, l'unité de commande (26) étant configurée pour commander une zone ovale(32) éclairée de la source de lumière et un bord extérieur sombre (33), et/ou l'unité de commande (26) étant configurée pour commander l'affichage de couleurs différentes simultanément par les sources de lumière, et/ou l'unité de commande (26) étant configurée pour commander un éclairage alterné par lesdites sources de lumière.

12. Procédé d'inspection de plaquettes semi-conductrices, dans lequel une plaquette semi-conductrice à inspecter est apportée par au moins un élément de support appartenant à un bras (30) de transport, des branches (1B, 19) distantes faisant partie d'une pince saisissent des bords opposés de la plaquette, la pince (15) tourne autour d'un arbre faisant passer la plaquette d'une position sensiblement horizontale à une position sensiblement verticale, et au moins deux systèmes d'inspection disposés d'un côté et de l'autre de la plaquette en position sensiblement verticale, symétriquement par rapport au plan passant par la plaquette, sont actionnés lorsque la plaquette est immobile en position sensiblement verticale,
dans lequel chacun des systèmes d'inspection comprend au moins une source de lumière et au moins une caméra (13, 14), chaque source de lumière comprenant un écran (9, 10) sensiblement parallèle au plan de la plaquette (11) et positionné pour émettre un faisceau incident vers une des surfaces de la plaquette, chaque caméra (13, 14) étant positionnée pour capter la lumière réfléchie par la surface de la plaquette lui faisant face.

## Patentansprüche

1. Vorrichtung zur Prüfung (1) von Halbleiterwafern, umfassend einen Förderarm (30) für Wafer mit mindestens einem Waferträgerelement, **dadurch gekennzeichnet, dass** sie eine Greifzange (15) zum Greifen der Wafer umfasst, wobei die Greifzange (15) zwei beabstandete Schenkel (18, 19) umfasst, welche zum Halten von gegenüber liegenden Rändern des Wafers eingerichtet sind, wobei die Greifzange (15) drehbar auf einer Welle angebracht ist, um den Wafer zwischen einer im Wesentlichen horizontalen Position und einer im Wesentlichen vertikalen Position drehen zu können, und mindestens zwei Prüfsysteme, welche links und rechts von dem im Wesentlichen vertikal liegenden Wafer, zu der sich durch den Wafer erstreckenden Ebene symmetrisch angeordnet sind, wobei die Prüfsysteme jeweils mindestens eine Lichtquelle und mindestens eine Kamera (13, 14) umfassen, wobei jede Lichtquelle einen Bildschirm (9, 10) umfasst, der im Wesentlichen parallel zur Ebene des Wafers (11) verläuft und derart gelagert ist, um einen in Richtung einer Oberfläche des Wafers einfallenden Lichtstrahl auszustrahlen, wobei jede Kamera (13, 14) derart gelagert ist, um das durch die ihr gegenüber liegenden Oberfläche des Wafers reflektierte Licht einzufangen, wobei die Prüfsysteme getätigt werden, wenn der Wafer in der im Wesentlichen vertikalen Position unbewegt liegt.

2. Vorrichtung nach Anspruch 1, bei welcher der Förderarm (30) mindestens zwei Gelenkachsen umfasst und durch einen Revolverkopf (28) getragen wird, welcher mindestens einen Förderarm für Wafer trägt, wobei der Revolverkopf (28) verschiebbar auf einer Gleitführung (29) angebracht ist.

3. Vorrichtung nach einem der vorhergehenden Ansprüche, bei welcher jeder Schenkel (18, 19) der Greifzange eine Nut (20) aufweist, welche auf einer dem anderen Schenkel zugewandten Oberfläche ausgebildet ist.

4. Vorrichtung nach dem vorhergehenden Anspruch, bei welcher die Nut (20) eine allgemeine V-Form aufweist.

5. Vorrichtung nach einem der beiden vorhergehenden Ansprüche, bei welcher mindestens einer der Schenkel in einer im Wesentlichen senkrecht zur Ebene des zwischen den Schenkeln gehaltenen Wafers verlaufenden Achse schwenkbar angebracht ist.

6. Vorrichtung nach einem der vorhergehenden Ansprüche, bei welcher die Förderelemente einen seitlichen Bewegungsplatzbedarf kleiner als die Öffnungsweite zwischen den Schenkeln der Greifzange (15) aufweisen.

7. Vorrichtung nach einem der vorhergehenden Ansprüche, bei welcher jede Lichtquelle einen Monitor (9, 10) umfasst, dessen kleinste Abmessung größer als 1,5-mal die größte Öffhungsweite zwischen den Schenkeln der Greifzange ist.

8. Vorrichtung nach dem vorhergehenden Anspruch, bei welcher der Monitor (9, 10) einen LCD- oder Plasmabildschirm umfasst.

9. Vorrichtung nach einem der vorhergehenden Ansprüche, bei welcher die Kamera (13, 14) oberhalb der Lichtquelle angeordnet ist.

10. Vorrichtung nach einem der vorhergehenden Ansprüche, eine Steuereinheit (26) umfassend, welche zur Steuerung der Anzeige von parallelen Streifen durch die Lichtquellen eingerichtet ist.

11. Vorrichtung nach dem vorhergehenden Anspruch, bei welcher die Steuereinheit (26) mindestens einen mit einer Kamera verbundenen Ausgang und mindestens einen mit der entsprechenden Lichtquelle verbundenen Ausgang zur Synchronisierung der Kamera und der Lichtquelle umfasst, wobei die Steuereinheit (26) dazu eingerichtet ist, einen beleuchteten, ovalen Teilbereich (32) der Lichtquelle und einen dunklen Außenrand (33) zu steuern, und/ oder wobei die Steuereinheit (26) dazu eingerichtet ist, die Anzeige von verschiedenen Farben gleichzeitig durch die Lichtquellen zu steuern, und/oder wobei die Steuereinheit (26) dazu eingerichtet ist, eine alternierende Beleuchtung durch die Lichtquellen zu steuern.

12. Verfahren zur Prüfung von Halbleiterwafern, bei welchem ein zu prüfender Halbleiterwafer durch mindestens ein zu einem Förderarm (30) gehörendes Trägerelement gebracht wird, beabstandete, zu einer Greifzange gehörende Schenkel (18, 19) gegenüberliegende Ränder des Wafers greifen, die Greifzange (15) sich um eine Welle dreht und dabei der Wafer von einer im Wesentlichen horizontalen Position in eine im Wesentlichen vertikale Position bringt, und mindestens zwei Prüfsysteme, welche links und rechts von dem im Wesentlichen vertikal liegenden Wafer, zu der sich durch den Wafer erstreckenden Ebene symmetrisch angeordnet sind, betätigt werden, wenn der Wafer in der im Wesentlichen vertikalen Position unbewegt liegt,
bei welchem jedes der Prüfsysteme mindestens eine Lichtquelle und mindestens eine Kamera (13, 14) umfasst, wobei jede Lichtquelle einen Bildschirm (9, 10) umfasst, der im Wesentlichen parallel zur Ebene des Wafers (11) verläuft und derart gelagert ist, um einen in Richtung einer der Oberflächen des Wafers einfallenden Lichtstrahl auszustrahlen, wobei jede Kamera (13, 14) derart gelagert ist, um das durch die ihr gegenüber liegenden Oberfläche des Wafers reflektierte Licht einzufangen.

## Claims

1. Semiconductor wafer inspection device (1) comprising a wafer transport arm (30) provided with at least one wafer support element, **characterized by** the fact that it comprises a wafer gripper (15), the gripper (15) comprising two spaced-apart branches (18, 19) configured to hold the opposite edges of the wafer, the gripper (15) being mounted so as to rotate on a shaft in order to be able to rotate the wafer between a substantially horizontal position and a substantially vertical position, and at least two inspection systems arranged on one side of the wafer and on the other in a substantially vertical position, symmetrically with respect to the plane passing through the wafer, each of the inspection systems comprising at least one light source and at least one camera (13, 14), each light source comprising a screen (9, 10) substantially parallel to the plane of the wafer (11) and positioned in order to emit an incident beam towards one of the surfaces of the wafer, each camera (13, 14) being positioned in order to capture the light reflected by the surface of the wafer facing it, the inspection systems being actuated when the wafer is immobile in a substantially vertical position.

2. Device according to claim 1, in which the transport arm (30) comprises at least two axes of articulation and is supported by a turret (28) supporting at least one wafer transport arm, the turret (28) being mounted in translation on a slide (29).

3. Device according to one of the preceding claims, in which each branch (18, 19) of the gripper has a groove (20) provided on a surface arranged facing the other branch.

4. Device according to the preceding claim, in which the groove (20) is generally V-shaped.

5. Device according to one of the preceding two claims, in which at least one of the branches is mounted swivelling about an axis substantially perpendicular to the plane of the wafer held between said branches.

6. Device according to one of the preceding claims, in which the transport elements have a lateral space requirement less than the gap between the branches of the gripper (15).

7. Device according to one of the preceding claims, in which each light source comprises a monitor (9,10) with the smallest dimension being greater than one and a half times the maximum gap between the branches of the gripper.

8. Device according to the preceding claim, in which the monitor (9, 10) comprises an LCD or plasma screen.

9. Device according to one of the preceding claims, in which the camera (13,14) is arranged above the light source.

10. Device according to one of the preceding claims, comprising a control unit (26) configured in order to control the display of parallel rays by the light sources.

11. Device according to the preceding claim, in which the control unit (26) comprises at least one output connected to a camera and at least one output connected to the corresponding light source in order to synchronize said camera and said light source, the control unit (26) being configured in order to control an illuminated oval zone (32) of the light source and a dark outer edge (33), and/or the control unit (26) being configured in order to control the display of different colours simultaneously by the light sources, and/or the control unit (26) being configured in order to control an alternating illumination by said light sources.

12. Method for inspecting semiconductor wafers, in which a semiconductor wafer to be inspected is brought by at least one support element belonging to a transport arm (30), spaced-apart branches (18, 19) forming part of a gripper taking hold of opposite edges of the wafer, the gripper (15) rotates about a shaft causing the wafer to pass from a substantially horizontal position to a substantially vertical position, and at least two inspection systems arranged on one side of the wafer and on the other in a substantially vertical position, symmetrically with respect to the plane passing through the wafer, are actuated when the wafer is immobile in a substantially vertical position,
in which each of the inspection systems comprises at least one light source and at least one camera (13, 14), each light source comprising a screen (9, 10) substantially parallel to the plane of the wafer (11) and positioned in order to emit an incident beam towards one of the surfaces of the wafer, each camera (13, 14) being positioned in order to capture the light reflected by the surface of the wafer facing it.
